# EUROPEAN PATENT SPECIFICATION

(11) **EP 3 623 350 B1**
(45) Date of publication and mention of the grant of the patent: **06.08.2025**
(21) Application number: 19197562.2
(22) Date of filing: 16.09.2019
(51) Int. Cl.: C03C 3/19, C03C 3/32, C03C 4/00, C09K 11/88, C09K 11/02, C09K 11/56, C03C 4/10, C03C 14/00, H10K 102/00

(54) **LIGHT-EMITTING DIELECTRIC MATERIAL**
LICHTEMITTIERENDES DIELEKTRISCHES MATERIAL
MATÉRIAU DIÉLECTRIQUE ÉMETTEUR DE LA LUMIÈRE

(30) Priority: 14.09.2018 PL 42701518
(43) Date of publication of application: 18.03.2020
(73) Proprietor: Ensemble3 sp. z o.o, 01-919 Warszawa (PL)
(72) Inventor: Pawlak, Dorota Anna, 01-885 Warszawa (PL); Nowaczynski, Rafal, 05-260 Marki (PL); Gajc, Marcin, 03-316 Warszawa (PL); Buza, Marta, 02-364 Warszawa (PL); Klos, Andrzej, 00-019 Warszawa (PL); Surma, Barbara, 02-695 Warszawa (PL); Osewski, Pawel, 16-400 Suwalki (PL)
(74) Representative: JD&P Patent Attorneys Joanna Dargiewicz & Partners

(56) References cited:
- EP-A1- 2 562 146
- EP-A2- 2 570 396
- JACOB GJ ET AL.: "PbTe Quatum Dots in Tellurite Glass Miscrostructured Optical Fiber", SPIE, PO BOX 10 BELLINGHAM WA 98227-0010 USA, 4 April 2005 (2005-04-04), pages 690206-1 - 690206-5, XP040434327
- MENEZES LS ET AL.: "Nanoparticles and microspheres: tools to study the interaction of quantum emitters via shared optical modes", SPIE, PO BOX 10 BELLINGHAM WA 98227-0010 USA, 1 June 2004 (2004-06-01), pages 174 - 182, XP040180768
- DEMOURGUES A ET AL: "XAFS study of CdSe quantum dots in a silicate glass", NUCLEAR INSTRUMENTS & METHODS IN PHYSICS RESEARCH. SECTION B: BEAM INTERACTIONS WITH MATERIALS AND ATOMS, ELSEVIER BV, NL, vol. 97, no. 1/4, 1 May 1995 (1995-05-01), pages 166 - 168, XP004003955, ISSN: 0168-583X, DOI: 10.1016/0168-583X(94)00712-8
- TIRTHA S ET AL: "Nano Au enhanced upconversion in dichroic Nd^3^+:Au-antimony glass nanocomposites", SOLID STATE SCIENCES, ELSEVIER, PARIS, FR, vol. 11, no. 5, 13 February 2009 (2009-02-13), pages 1044 - 1051, XP026116702, ISSN: 1293-2558, [retrieved on 20090213], DOI: 10.1016/J.SOLIDSTATESCIENCES.2009.02.007
- MARCIN GAJC ET AL: "Nanoparticle Direct Doping: Novel Method for Manufacturing Three-Dimensional Bulk Plasmonic Nanocomposites", ADVANCED FUNCTIONAL MATERIALS, vol. 23, no. 27, 19 July 2013 (2013-07-19), DE, pages 3443 - 3451, XP055612610, ISSN: 1616-301X, DOI: 10.1002/adfm.201203116
- DEBASIS BERA ET AL: "Quantum Dots and Their Multimodal Applications: A Review", MATERIALS, vol. 3, no. 4, 24 March 2010 (2010-03-24), pages 2260 - 2345, XP055412133, DOI: 10.3390/ma3042260

## Description

The subject of the invention is a light-emitting dielectric material applicable in plasmonics, optoelectronics, optics, photonics, telecommunications, medicine, and biology.

Luminescent volumetric materials comprising of glass matrix doped with quantum dots are already known. As: Achermann M. et al.states in article Nature 2004, 429, 642-6, the energy gap in quantum dots depends on their diameter. Therefore, length of emitted light wave depends not only on the chemical composition of the dots, but also on their size and shape. This property together with narrow luminescence spectrum enables extensive use of quantum dots areas of modem technology such as: production of luminescent diodes - Nozik A. Physica E. Low Dimens. Syst. Nanostruct. 2002, 14, 115-20; biosensors - Resch-Genger U.et al. Nat. Methods 2008, 5, 763-75; laser technology - Sellers I. et al. Electron. Lett. 2004, 40,1. If matrix contains several types of dots it is characterized by wide absorption band, therefore, it is possible to excite them with one light source of specific wavelength and receive material emitting light at two or more wavelengths. In publication of Dabbousi B.D. et al. J. Phys. Chem. B 1997, 101, 9463-9475 a possibility of producing tunable optical devices is presented, while Steckel et al. J. Soc. Info Display 2015, 23, 294-305 showed the possibility of producing LCD screens using micro-fibers doped with various types of quantum dots enabling transformation of blue light into white.

Volumetric active materials containing quantum dots in polymers matrix are also known and were presented by Pang L., Shen Y., Tetz K., Fainman Y. Opt. Express 2005, 13, 44-9. However, polymer matrices presented there can be used only at relatively low temperatures and the procedure of doping with quantum dots often leads to their agglomeration.

Another already studied materials are built from glass matrix doped with nanocrystals using the sol-gel method, as presented by Rajh T. et el. Chem. Phys. Lett. 1988, 143 305-8. However, use of this method is limited mainly to silica glasses and doping one matrix with several types of nanocrystals is a technologically difficult process.

EP 2 562 146 A1 discloses a quantum dot-glass composite luminescent material, the base of which is nanometer pore glass. The nanometer pore glass is doped with luminescent quantum dot. A manufacturing method for the luminescent material is also disclosed, which includes the following steps: step one, preparing an aqueous or organic solution of a single luminescent quantum dot, or a mixed aqueous or organic solution of two or more luminescent quantum dots; step two, immersing the nanometer pore glass in the solution of step one for at least ten minutes; step three, taking the immersed nanometer pore glass out of the solution and drying it in the air, wrapping and packaging the nanometer pore glass with resin, and obtaining the quantum dot-glass composite luminescent material after solidifying it.

The light-emitting dielectric material presented herein can be obtained by direct nanoparticle doping method known from Gajc M. et al. Adv. Funct. Mater. 2013, 23, 3443-3451 and patent no. EP2570396 A2. This method allows for easy doping of a volume glass matrix with several dopant types in the form of nanoparticles, quantum dots as well as activator ions.

The light-emitting dielectric material according to the invention as defined in claim 1.

The light-emitting dielectric material can be obtained in the form of plates, rods, and other volumetric structures.

The light-emitting dielectric material may contain organic and/or inorganic glass as a dielectric matrix, with the inorganic glass being preferred, in particular borate phosphate glass with addition of sodium resulting in chemical formula (1-x) NaPO₃ - xB₂O₃ called NBP, where 0.1<x <0.5, or tellurium glass with 80 mol% TeO₂ -10 mol% ZnO - 10 mol% Na₂CO₃ referred to as TZN, or fluoride glass consisting of fluorine compounds ZrF₄-BaF₂-LaF₃-AlF₃-NaF referred to as ZBLAN.

In the claimed invention, the light-emitting dielectric material contains CdTe semiconductor quantum dots in dielectric matrix. In an embodiment not forming part of the claimed invention, the semiconductor quantum dots are preferably from the presented group of compounds: CdSe, CdS, CdSe / ZnS, InAs, InP, HgTe, Ag₂S, Ag₂Se, CuInS₂, CuInSe₂, as well as dots based on lead: PbSe, PbS with a coating, most preferably quantum dots CdSe / ZnS - where CdSe is the core while ZnS is the shell. Melting temperature of quantum dots should be above the matrix melting point. of the matrix. The dielectric matrix can contain more than one type of quantum dots. Preferably the content of each type of quantum dots is greater than 0.1 wt%.

In the claimed invention, the light-emitting dielectric materials contains in the dielectric matrix Ag plasmonic nanoparticles. In an embodiment not forming part of the claimed invention, the light-emitting dielectric materials contains in the dielectric matrix preferably metallic or semi-conductive nanoparticles characterized by low optical losses, negative value of the real part of electrical permeability - Re (ε) <0 in the UV / VIS / NIR range of the electromagnetic wavelength, and melting temperature higher than the matrix melting temperature, preferably metal nanoparticles from the group Au, Al, Cu, Pt, Ni, Mo, Co, TiN, most preferably silver nanoparticles.

The light-emitting dielectric material presented in the invention is a volumetric material that, in an embodiment not forming part of the invention, can be doped simultaneously with several types of quantum dots and metal or semiconductor nanoparticles in one technological process. The light-emitting dielectric material according to the invention can be prepared with a planned length of the emitted light wave due to possibility of using quantum dots of different diameters and chemical composition. Simultaneous doping with several types of quantum dots will allow production of light-emitting material at two or even more wavelengths. Whereas co-doping with quantum dots and nanoparticles presenting plasmonic properties can increases emission of quantum dots, thanks to the use of energy transfer between nanoparticles and quantum dots phenomenon.

The light-emitting dielectric material according to the invention is used, depending on the needs, in the form of rods, plates, layers or other prepared fragments thereof.

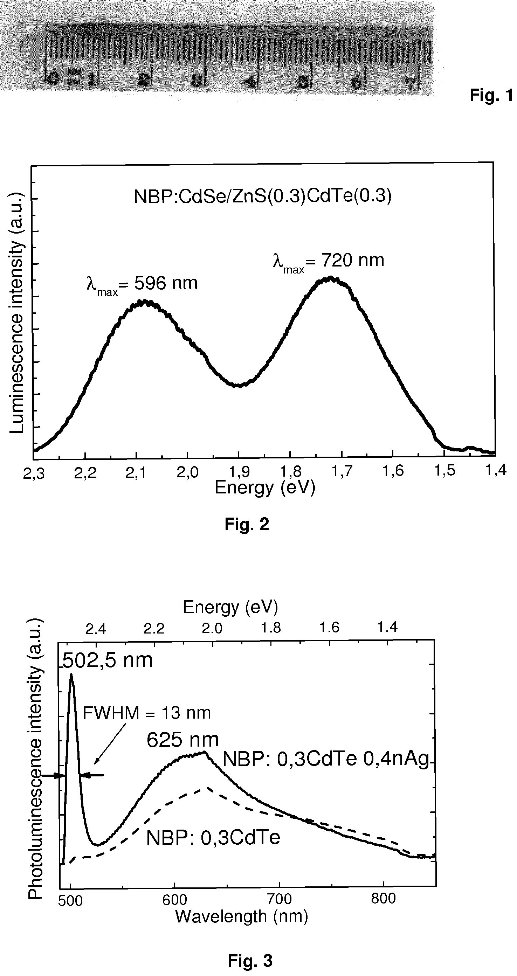

The example 2 below presents the material according to the claimed invention in a specific case of its implementation, without limiting its scope of application, based on the drawings where Fig. 3 luminescence spectrum measured for the NBP matrix doped individually with CdTe quantum dots of 1.5nm diameter together with double: CdTe quantum dots of 1.5 nm diameter, and silver nanoparticles in an amount of 0.4 wt.%. It is noted that Fig. 2 presents luminescence spectrum measured for a rod not corresponding to the the claimed invention.

### Example 1

Glass matrix of borate phosphate glass with the formula Na₅B₂P₃0₁₃ containing 0.3 wt.% CdTe quantum dots of 5.4 nm diameter and 0.3 wt.% CdSe / ZnS quantum dots of 3.1 nm diameter. The sample material is prepared in a form of a rod of 5 mm diameter using the micro pulling-down method. Its luminescence spectrum shows two peaks at 596 nm and 720 nm resulting from emission of CdSe / ZnS and CdTe, respectively, as shown in Figure 2.

### Example 2

Borate-phosphate glass matrix with the formula NaₛB₂P₃O₁₃doped with 0.3wt% of CdTe quantum dots of 1.5 nm diameter and 0.4 wt% Ag nanoparticles of 20 nm diameter. The luminescence spectrum in the case of simultaneous doping with quantum dots and nanoparticles shows significant amplification of CdTe short-wave emission with a wavelength of 502.5 nm, as shown in Figure 3. The half peak's width FWHM is equal to 13 nm.

## Claims

1. A light-emitting dielectric material, containing a dielectric glass matrix with high transmission in the 0.35 - 5 µm wavelength range and having positive value of the real part of permittivity Re(ε)>0 in the UV/VIS/NIR electromagnetic wavelength range and low dielectric losses, said dielectric glass matrix being doped with:
(i) semiconductor quantum dots of 1.5 - 10 nm in diameter and
(ii) plasmonic metallic nanoparticles with a melting point higher than the matrix melting point, low optical losses, and negative value of the real part of permittivity Re(ε)<0 in the UV/VIS/NIR electromagnetic wavelength range, said plasmonic metallic nanoparticles showing plasmonic resonance in the 0.35 - 5 µm wavelength range,
wherein the semiconductor quantum dots are in an amount of 0.3 wt. % and are cadmium telluride, CdTe, quantum dots of 1.5 nm diameter, and the plasmonic metallic nanoparticles are in an amount of 0.4 wt. % and are silver, Ag, nanoparticles of 20 nm diameter.

2. The light-emitting dielectric material according to claim 1, wherein the dielectric matrix is organic and/or inorganic glass.

3. The light-emitting dielectric material according to claim 1 or 2, wherein the dielectric matrix is inorganic borate-phosphate glass with the addition of sodium with the chemical formula (1-x) NaPO₃₋xB₂O₃, where 0.1 <x <0.5.

4. The light-emitting dielectric material according to claim 1 or 2, wherein the dielectric matrix is inorganic zinc-telluric glass with an addition of sodium.

5. The light-emitting dielectric material according to claim 4, wherein the inorganic zinctellurium glass is composed of 80 mol% TeO₂, 10 mol% ZnO and 10 mol% Na₂CO₃.

6. The light-emitting dielectric material according to claim 1 or 2, wherein the dielectric matrix contains inorganic ZBLAN glass consisting of the fluorine compounds: ZrF₄,BaF₂, LaF₃, AlF₃, NaF.

## Patentansprüche

1. Lichtemittierendes dielektrisches Material, das eine dielektrische Glasmatrix mit hoher Transmission im Wellenlängenbereich von 0,35 bis 5 µm und mit einem positiven Wert des Realteils der Permittivität Re(ε) > 0 im elektromagnetischen Wellenlängenbereich UV/VIS/NIR sowie geringen dielektrischen Verlusten enthält, wobei die dielektrische Glasmatrix dotiert ist mit:
(i) Halbleiter-Quantenpunkten mit einem Durchmesser von 1,5 bis 10 nm und
(ii) plasmonischen metallischen Nanopartikeln mit einem Schmelzpunkt über dem Schmelzpunkt der Matrix, geringen optischen Verlusten und einem negativen Wert des Realteils der Permittivität Re(ε) < 0 im elektromagnetischen Wellenlängenbereich UV/VIS/NIR, wobei die plasmonischen metallischen Nanopartikel im Wellenlängenbereich von 0,35 bis 5 µm eine plasmonische Resonanz zeigen,
wobei die Halbleiter-Quantenpunkte in einer Menge von 0,3 Gew.-% vorliegen und Cadmiumtellurid, CdTe, Quantenpunkte mit einem Durchmesser von 1,5 nm sind, und die plasmonischen metallischen Nanopartikel in einer Menge von 0,4 Gew.-% vorliegen und Silber, Ag, Nanopartikel mit einem Durchmesser von 20 nm sind.

2. Lichtemittierendes dielektrisches Material nach Anspruch 1, wobei die dielektrische Matrix organisches und/oder anorganisches Glas ist.

3. Lichtemittierendes dielektrisches Material nach Anspruch 1 oder 2, wobei die dielektrische Matrix anorganisches Borat-Phosphat-Glas mit Zusatz von Natrium mit der chemischen Formel (1-x) NaPO₃-xB₂O₃ ist, wobei 0,1 < x < 0,5 ist.

4. Lichtemittierendes dielektrisches Material nach Anspruch 1 oder 2, wobei die dielektrische Matrix anorganisches Zink-Tellur-Glas mit Zusatz von Natrium ist.

5. Lichtemittierendes dielektrisches Material nach Anspruch 4, wobei das anorganische Zink-Tellur-Glas aus 80 Mol-% TeO₂, 10 Mol-% ZnO und 10 Mol-% Na₂CO₃ zusammengesetzt ist.

6. Lichtemittierendes dielektrisches Material nach Anspruch 1 oder 2, wobei die dielektrische Matrix anorganisches ZBLAN-Glas enthält, das aus den Fluorverbindungen besteht: ZrF₄, BaF₂, LaF₃, AlF₃, NaF.

## Revendications

1. Matériau diélectrique émetteur de lumière, contenant une matrice de verre diélectrique à transmission élevée dans la plage de longueurs d'onde 0,35 - 5 µm et ayant une valeur positive de la partie réelle de la permittivité Re(ε)>0 dans la plage de longueurs d'onde électromagnétiques UV/VIS/NIR et de faibles pertes diélectriques, ladite matrice de verre diélectrique étant dopée avec :
(i) des points quantiques semi-conducteurs de 1,5 à 10 nm de diamètre et
(ii) des nanoparticules métalliques plasmoniques ayant un point de fusion supérieur à celui de la matrice, de faibles pertes optiques et une valeur négative de la partie réelle de la permittivité Re(ε)<0 dans la plage de longueurs d'onde électromagnétiques UV/VIS/NIR, lesdites nanoparticules métalliques plasmoniques présentant une résonance plasmonique dans la plage de longueurs d'onde de 0,35 à 5 µm,
dans lequel les points quantiques semi-conducteurs sont en quantité de 0,3 % en poids et sont des points quantiques de tellurure de cadmium (CdTe) d'un diamètre de 1,5 nm, et
les nanoparticules métalliques plasmoniques sont en quantité de 0,4 % en poids et sont des nanoparticules d'argent (Ag) de 20 nm de diamètre.

2. Matériau diélectrique émetteur de lumière selon la revendication 1, dans lequel la matrice diélectrique est un verre organique et/ou inorganique.

3. Matériau diélectrique émetteur de lumière selon la revendication 1 ou 2, dans lequel la matrice diélectrique est un verre de borate-phosphate inorganique auquel avec addition de sodium, selon la formule chimique (1-x) NaPO₃-xB₂O₃, où 0,1 <x <0,5.

4. Matériau diélectrique émetteur de lumière selon la revendication 1 ou 2, dans lequel la matrice diélectrique est un verre inorganique de zinc-tellure avec addition de sodium.

5. Matériau diélectrique émetteur de lumière selon la revendication 4, dans lequel le verre inorganique de zinc-tellure est composé de 80 % en moles de TeO₂, 10 % en moles de ZnO et 10 % en moles de Na₂CO₃.

6. Matériau diélectrique émetteur de lumière selon la revendication 1 ou 2, dans lequel la matrice diélectrique contient un verre inorganique ZBLAN constitué des composés fluorés : ZrF₄, BaF₂, LaF₃, AlF₃, NaF.
